# EUROPEAN PATENT APPLICATION

(11) **EP 1 772 430 A1**
(43) Date of publication of application: **11.04.2007**
(21) Application number: 05753511.4
(22) Date of filing: 23.06.2005
(51) Int. Cl.: C01B 33/027, B22D 25/04, F27D 5/00, H01L 21/02, B22D 21/00

(54) **TUBULAR CONTAINER MADE OF CARBON**

(30) Priority: 23.06.2004 JP 2004185436
(71) Applicant: TOKUYAMA CORPORATION, Shunana-shi, Yamaguchi 745-8648 (JP)
(72) Inventor: NAKASHIMA, Junichirou, Shunan-shi, Yamaguchi 7458648 (JP); SAKITA, Manabu, Shunan-shi, Yamaguchi 7458648 (JP); ODA, Hiroyuki, Shunan-shi, Yamaguchi 7458648 (JP); SUGIMURA, Shigeki, Shunan-shi, Yamaguchi 7458648 (JP)
(74) Representative: Hall, Matthew Benjamin
(86) International application number: PCT/JP2005/011518
(87) International publication number: WO 2006/001328

(57) **Abstract**

It is an object of the present invention to prevent leakage of a raw material gas or molten silicon in a carbon columnar container which is constructed by connecting plural carbon cylindrical members to each other by a screw portion provided along the periphery of an end of each of the cylindrical members, by sealing a gap present at the connection portion through a high-reliability method that causes no cracking or the like. The carbon columnar container of the invention is a carbon columnar container constructed so as to form a multistage structure by connecting plural carbon cylindrical members to each other by a screw portion provided along the periphery of an end of each of the cylindrical members, wherein each of the cylindrical members connected to each other has such a ring-shaped plane extending from the inner peripheral wall in the diameter direction as to form a ring-shaped butt area on the inner peripheral wall side when the cylindrical members are connected, and the sum of surface roughness (Ra) of the ring-shaped planes to form the butt area is in the range of 1 to 100 µm.

## Description

### TECHNICAL FIELD

The present invention relates to a novel carbon columnar container which comprises plural carbon molded articles, an inner surface of which comes into contact with a silicon melt and which is favorably used for silicon deposition reaction caused by decomposition/reduction reaction of silanes.

### BACKGROUND ART

In the field of semiconductors or solar batteries, importance of silicon products has increased in recent years. With such increase, apparatuses to treat silicon are made larger in order to efficiently produce silicon products, and also containers to treat silicon in a molten state (silicon melt) tend to be made larger.

The container to treat a silicon melt is, for example, a container wherein silicon is melted to manufacture ingots or wafers or a container on an inner surface of which silanes such as trichlorosilane (SiHC1₃, referred to as "TCS" hereinafter) and monosilane (SiH₄) are brought into contact with a raw material gas for silicon deposition containing a reducing gas such as hydrogen to deposit silicon.

As the material of the container to treat a silicon melt, quartz, ceramic, carbon or the like is employed, and from the viewpoints of processability, durability, heat resistance, chemical stability, contamination with impurities, etc., or depending upon the use purpose, carbon is preferably employed.

More specifically, in an apparatus for manufacturing polycrystal silicon wherein silanes are brought into contact with hydrogen on an inner surface of a columnar container (reaction container) to deposit silicon and the silicon deposited on the inner surface is melted and recovered, carbon is employed as the material of the columnar container that comes into contact with a silicon melt (see patent document 1).

As the structure of the columnar container, an integrally molded structure without seam is most preferable from the viewpoints of hermetic property and durability, but it is difficult to form a large-sized integrally molded article of homogeneous properties from carbon, and even if a container to be formed is small, it is difficult to form an integrally molded article of complicated shape. On this account, a carbon columnar container conventionally used is a container which is allowed to have desired size and shape by forming plural cylindrical carbon molded articles and connecting them screwing in or using a binder.

In the columnar container of such a connection type structure wherein connection is made by screwing in, it is impossible to completely remove a gap at the butt portion between the carbon molded articles even if processing accuracy of each molded article is increased. A silicon melt has high penetrability, so that it penetrates into the container wall through a slight gap at the butt portion. In the case where a large amount of a silicon melt penetrates into the container wall, the silicon is solidified and expanded inside the container wall, and if the silicon is expanded to exceed the strength of the carbon molded article, a problem of occurrence of cracks or the like in the carbon molded article is brought about. Moreover, if a raw material gas or a silicon melt penetrates through a gap at the butt portion and leaks out, there occur various problems, such as lowering of reaction efficiency and marked contamination or damages of a heating device, a raw material gas feed pipe, a cooling device, a heat insulting material and other reaction device members of the reaction container.

On the other hand, a method for connecting carbon molded articles to each other using a binder (sealing material) is also known (see patent document 2). In this method, the gap at the butt portion of the carbon molded articles is filled with a carbon powder and a silicon powder, and these powders are allowed to react with each other by heating to form a silicon carbide layer (sealing layer), whereby the carbon molded articles are connected together.

Patent document 1: Japanese Patent Laid-Open Publication No. 29726/2002

Patent document 2: Japanese Patent Laid-Open Publication No. 257981/1995

### DISCLOSURE OF THE INVENTION

### PROBLEMS TO BE SOLVED BY THE INVENTION

However, if a carbon columnar container having, as a connection portion, a silicon carbide layer previously formed by the method described in the patent document 2 is used as a container whose inner surface comes into contact with a silicon melt, e.g., a reaction container for manufacturing polycrystal silicon, there are problems that cracks occur in the carbon molded article or the silicon carbide layer in the long-term operation accompanied by a cycle of temperature-raising and temperature-lowering operations and that the silicon carbide layer is deteriorated during the long-term use and a silicon melt leaks outside the reaction container.

The reason of occurrence of cracks is presumably that if the thickness of the silicon carbide layer at the connection portion is increased, a great strain is applied to the carbon molded article because of a difference in thermal expansion between the carbon molded article and the silicon carbide layer. The reason of deterioration of the silicon carbide layer is presumably that the silicon carbide layer formed by the aforesaid method has a function of preventing leakage of a silicon melt but partially has heterogeneous composition, so that elution of the silicon carbide layer into the silicon melt takes place though it is slight.

Accordingly, it is an object of the present invention to provide a carbon columnar container which comprises plural carbon molded articles, an inner surface of which comes into contact with a silicon melt and which can prevent leakage of a silicon melt. In particular, it is an object of the invention to provide a carbon columnar container which can be used as a reaction container free from leakage of a silicon melt in the manufacture of silicon wherein a long-term operation accompanied by a temperature raising/lowering cycle is carried out.

### MEANS TO SOLVE THE PROBLEMS

The summary of the present invention that solves the above problems is as follows.
(1) A carbon columnar container constructed so as to form a multistage structure by connecting plural carbon cylindrical members to each other by a screw portion provided along the periphery of an end of each of the cylindrical members, wherein:
   each of the cylindrical members connected to each other has such a ring-shaped plane extending from the inner peripheral wall in the diameter direction as to form a ring-shaped butt area on the inner peripheral wall side when the cylindrical members are connected, and
   the sum of surface roughness (Ra) of the ring-shaped planes to form the butt area is in the range of 1 to 100 µm.
(2) The carbon columnar container as stated in (1), which has a ring-shaped enlarged gap formed at the end, in the outer peripheral direction, of the ring-shaped plane, and wherein a carbon material is placed at the enlarged gap.
(3) The carbon columnar container as stated in (1) or (2), wherein the inner peripheral wall surface has been converted into silicon carbide.

### EFFECT OF THE INVENTION

The carbon columnar container of the invention is constructed by connecting plural carbon cylindrical members to each other by a screw portion provided along the periphery of an end of each of the cylindrical members, and a gap at the connection portion in the inner peripheral wall is sealed. Therefore, when the carbon columnar container of the invention is used for, for example, manufacturing silicon, there is no fear of breakage of the connection portion attributable to penetration and solidification of a silicon melt in the container wall. Further, because leakage of a raw material gas or a silicon melt due to penetration thereof through the container wall does not occur, the reaction efficiency is excellent, and the circumference of the columnar container is neither contaminated nor damaged. Because the screw portions are surely fixed without any strain and are not loosened, the connection portion has high mechanical strength. By connecting plural members, a large-sized columnar container having sealing property, reliability and strength comparable to those of an integrally molded article can be obtained.

### BRIEF DESCRIPTION OF THE DRAWINGS

Fig. 1 is a perspective view showing a typical embodiment of a columnar container of the present invention.
Fig. 2 is a schematic view of connection portions of cylindrical members for constituting a columnar container of the present invention.
Fig. 3 is a schematic view of connection portions of cylindrical members for constituting a columnar container of the present invention.
Fig. 4 shows a state where a carbon material is placed at the end, in the outer peripheral direction, of a butt area.
Fig. 5 shows a state where a carbon material is placed at the end, in the outer peripheral direction, of a butt area.
Fig. 6 shows a state where a carbon material is placed at the end, in the outer peripheral direction, of a butt area.
Fig. 7 shows a state where a carbon material is placed at the end, in the outer peripheral direction, of a butt area.

### Description of reference numerals

1: Columnar container
2: Cylindrical member
3: Cylindrical member
4: Screw portion
5: Screw portion
6: Inner peripheral wall
7: Inner peripheral wall
8: Ring-shaped plane
9: Ring-shaped plane
10: Butt area
11: Carbon material

### BEST MODE FOR CARRYING OUT THE INVENTION

The present invention is described in more detail hereinafter, making reference to the accompanying drawings.

The carbon columnar container of the invention is constituted of plural carbon molded articles and is preferably applied particularly to uses where the inner surface of the columnar container comes into contact with a silicon melt.

Therefore, the carbon columnar container of the invention is, for example, a container for keeping a silicon melt, a conduit for transferring a silicon melt or a reaction container for manufacturing silicon.

In the case where the carbon columnar container of the invention is used as a reaction container for manufacturing silicon, the columnar container is a container wherein silicon can be formed by allowing TCS or the like and hydrogen to react with each other on an inner surface of the columnar container and the whole or a part of the silicon thus formed can be melted by heating the inner surface to not lower than a melting point (1430°C) of silicon. More specifically, the carbon columnar container of the invention can has a structure basically the same as that of a columnar container (reaction container) of a polycrystal silicon manufacturing apparatus described in Japanese Patent Laid-Open Publication No. 29726/2002, and is a large-sized one constituted of plural carbon molded articles. In this case, in an embodiment wherein the inner surface of the columnar container comes into contact with a silicon melt, it is possible that silicon is temporarily formed in a solid state on the inner surface and then the silicon is melted and brought into contact with the surface, or it is also possible that simultaneously with formation of silicon on the inner surface, the silicon is melted and brought into contact with the surface.

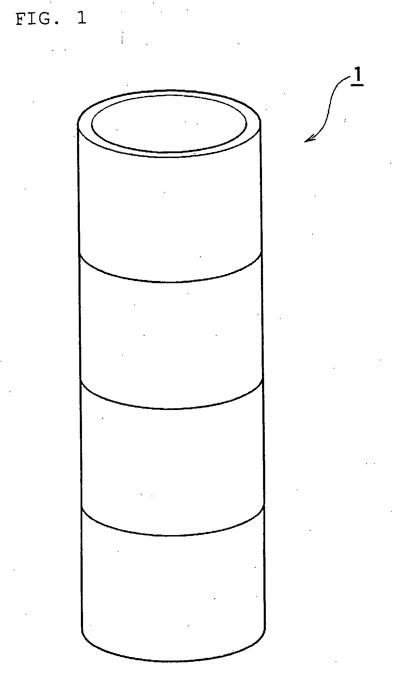

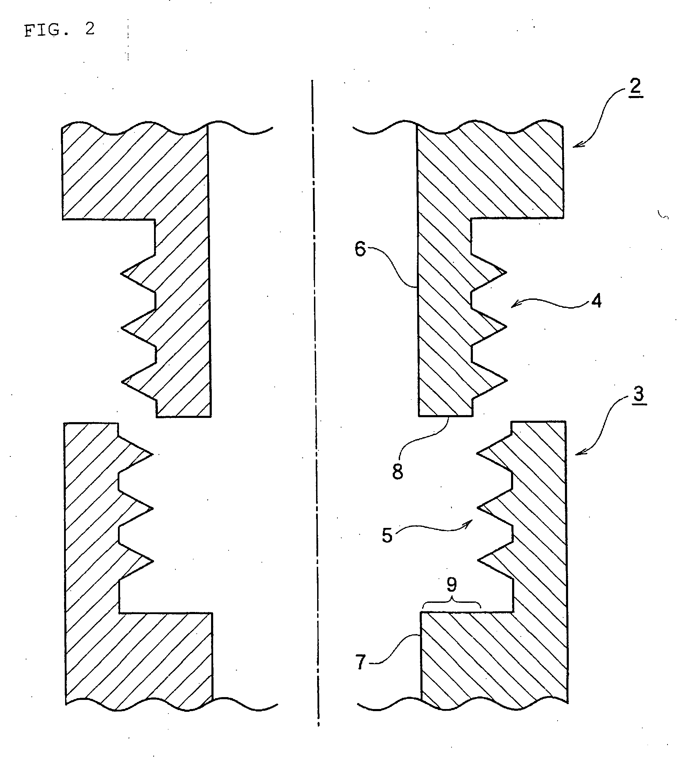

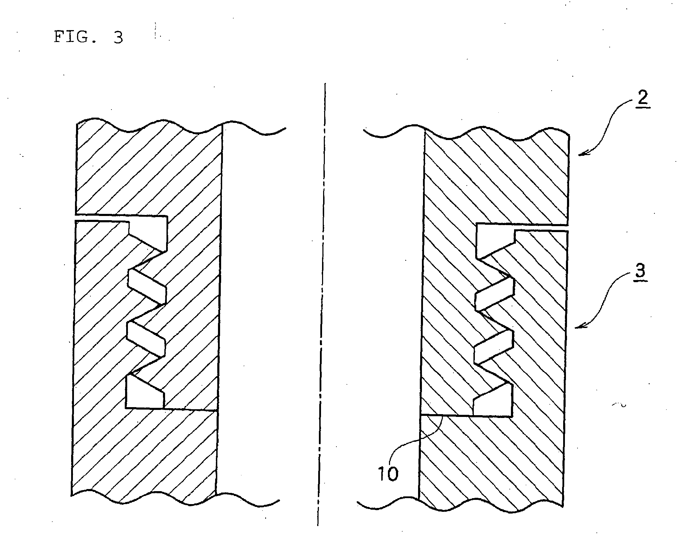

The carbon columnar container of the invention can be constructed by connecting plural cylindrical members in the axial direction. In Fig. 1, a perspective view of a typical embodiment of the carbon columnar container of the invention is shown. At the end of the individual cylindrical member, a screw portion is provided, and the screw portions of the members are screwed in each other to construct the columnar container 1 so as to form a multistage structure. Fig. 2 schematically shows sections of the connection portions of the cylindrical members 2 and 3 to be connected to each other. At the connection portions, the cylindrical members 2 and 3 are provided with screw portions 4 and 5 along the peripheries, respectively. Further, the cylindrical members 2 and 3 have ring-shaped planes 8 and 9, respectively, which extend from the inner peripheral walls 6 and 7, respectively, in the diameter direction. When the cylindrical members are connected by the screw portions, the ring-shaped planes 8 and 9 overlap each other to form a butt area 10 on the inner peripheral wall side, as shown in Fig. 3.

The sum (referred to as "Ra value" hereinafter) of surface roughness (Ra) of the ring-shaped planes 8 and 9 is in the range of 1 to 100 µm, preferably 1 to 50 µm. That the Ra value is such a value is significant when the inner peripheral wall of the container comes into contact with a silicon melt, as described later. Ra is measured in accordance with JIS B0601.

The columnar container constructed as above has a gap of a specific size on the inner peripheral wall side of each connection portion, said gap being attributable to the Ra value of the ring-shaped planes 8 and 9. By loosening the screw portions, the container can be disassembled into individual cylindrical members. By incorporating the columnar container into a silicon manufacturing apparatus and carrying out silicon formation reaction as described below, the above-mentioned gaps are all sealed, and the connection portions are fixed so as to be inseparable.

In the silicon manufacturing apparatus using the carbon columnar container of the invention, a raw material gas containing silanes is fed into the columnar container, and the columnar container is heated to form a silicon melt on an inner peripheral wall of the columnar container. Thereupon, carbon of the inner peripheral wall surface that has come into contact with silicon is converted into silicon carbide. At the same time, the silicon melt enters even a slight gap present at each connection portion of the inner peripheral wall to form silicon carbide. When carbon is converted into silicon carbide, the volume becomes twice. When the Ra value is in the above range, the gap present on the inner peripheral wall side of each connection portion is completely sealed by virtue of expansion in volume caused by the conversion into silicon carbide. If the Ra value is too large, the gap present on the inner peripheral wall side of each connection portion cannot be completely sealed even if the conversion into silicon carbide is carried out, resulting in a gap residue. The thickness of the silicon carbide layer formed by the conversion into silicon carbide is about several hundreds µm, so that a strain caused by a difference in coefficient of thermal expansion between the carbon member and the silicon carbide layer is extremely small. Therefore, the connection portion is not broken even if the strain is applied thereto.

In the carbon columnar container wherein conversion into silicon carbide has been carried out as above, the gaps present in the inner peripheral wall are completely sealed. In the subsequent silicon formation reaction, therefore, there is no fear of breakage of the connection portion attributable to penetration and solidification of a silicon melt in the container wall. Further, because leakage of a raw material gas or a silicon melt due to penetration thereof through the container wall does not occur, the reaction efficiency is excellent, and the circumference of the columnar container is neither contaminated nor damaged. Because the screw portions are surely fixed without any strain and are not loosened, the connection portion has high mechanical strength. Consequently, even if the columnar container is a large-sized one consisting of a large number of members connected, sufficient mechanical strength can be obtained by carrying out conversion into silicon carbide.

The aforesaid Ra value can be attained by subjecting the prescribed ring-shaped plane of each cylindrical member to grinding machine finish or milling machine finish or and then, if necessary, to polishing machine finish.

The width of each of the ring-shaped planes 8 and 9, which satisfy the Ra value, from the inner peripheral wall in the diameter direction has only to be not less than 1 mm because sealing is carried out by conversion into silicon carbide, but the width is preferably not less than 5 mm, more preferably not less than 10 mm.

The diameter of the container is not specifically restricted and can be properly selected according to the scale of the manufacturing apparatus. The length of the container can be arbitrarily determined by connecting many members.

The container can has a shape having a constant diameter at any position, as shown in Fig. 1, or can has a shape having different diameters at the different positions.

In the screw portion provided at the connection portion, a single-thread screw or a multiple-thread screw such as a double-thread screw is employed. As the number of threads, three threads are shown in Fig. 2 and Fig. 3, but the number of threads is not limited thereto and properly selected taking into account the size and the wall thickness of the container, the strength of carbon used, etc.

Although the material of carbon for forming the container is not specifically restricted, carbon having an isotropic material structure wherein a change in coefficient of thermal expansion due to the measuring direction is small is preferable because the container has a connecting structure.

It is particularly preferable that the carbon columnar container of the invention has a ring-shaped enlarged gap at the ends, in the outer peripheral direction, of the ring-shaped planes that form the butt area 10 and in the enlarged gap a carbon material 11 is placed. By virtue of the carbon material, a structure wherein the outer peripheral end of the butt area 10 is sealed by the carbon material 11 is obtained. As a result, even if a silicon melt penetrates along the butt area 10 toward the outside of the columnar container, leakage of the silicon melt is inhibited by the carbon material 11. That is to say, it is ascertained by the present inventors that when the carbon material 11 comes into contact with the silicon melt and is partially converted into silicon carbide, expansion in volume occurs as previously described, and also when the melt reaches the enlarged gap, the sealing effect of the carbon material 11 is efficiently exhibited.

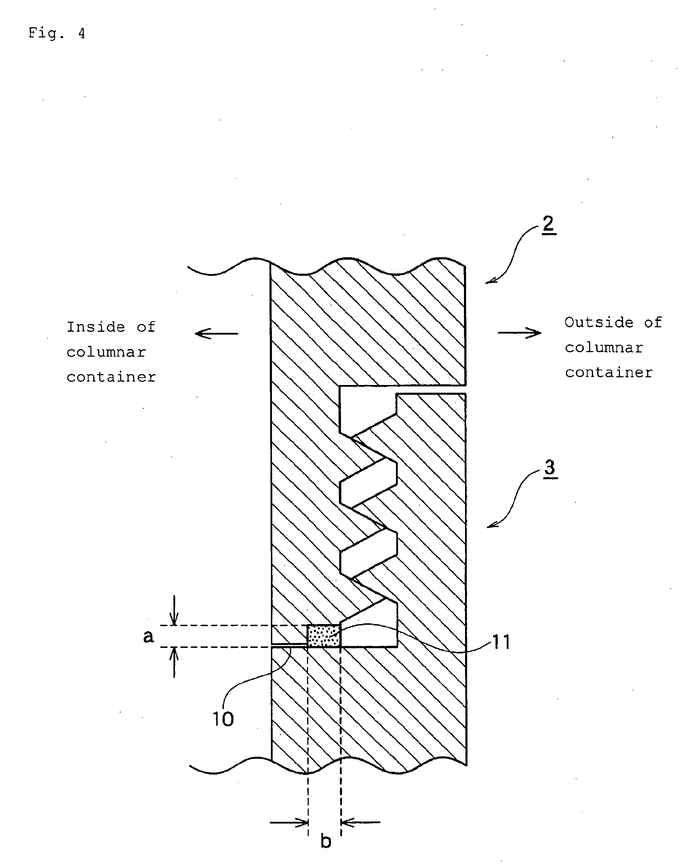

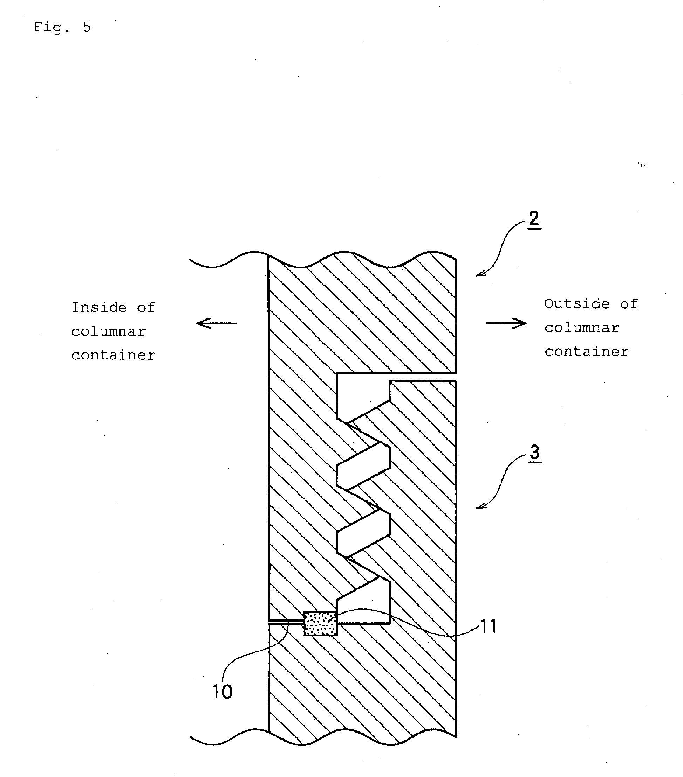

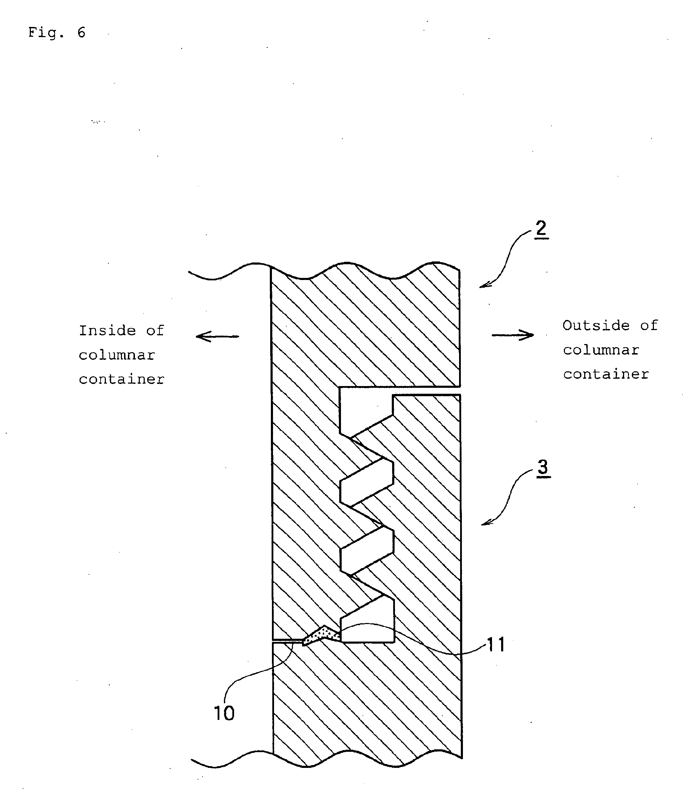

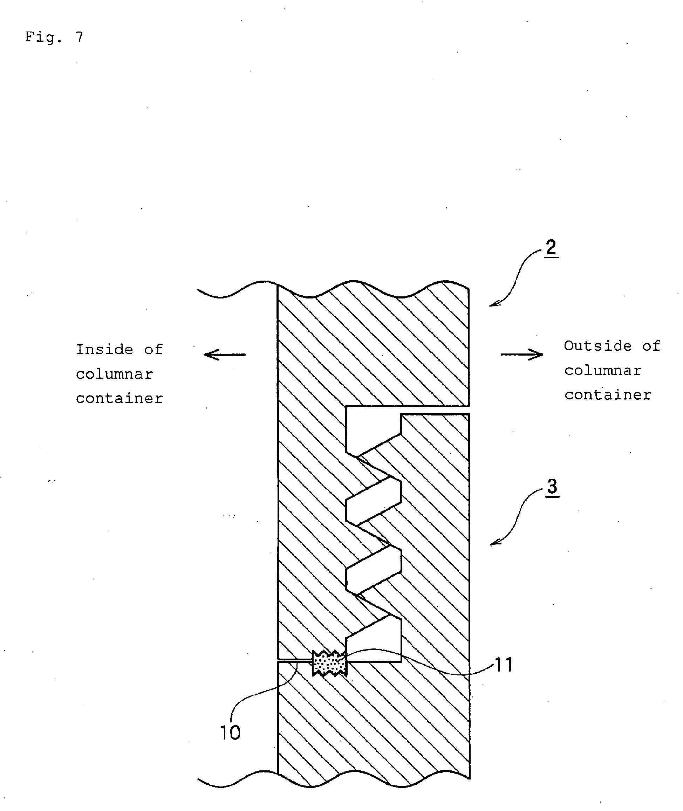

The enlarged gap is formed by providing a difference in level at the end, in the outer peripheral direction, of the ring-shaped plane or providing a wavy portion at said end. For example, Fig. 4 shows an embodiment wherein a difference in level is provided at the end of the ring-shaped plane of an upper cylindrical member 2 to form a cutaway portion and thereby form an enlarged gap. The cutaway portion may be formed in both of the cylindrical members 2 and 3 (Fig. 5). The sectional shape of the enlarged gap is not specifically restricted, and it may be a rectangular parallelepiped shape, an angular shape or another shape. Further, it is also possible that a cutaway portion of angular shape is provided in the upper cylindrical member 2 and a protruded portion of angular shape is provided in the lower cylindrical member 3, as shown in Fig. 6. Furthermore, the upper and the lower surfaces of the enlarged gap may be processed to give wavy surfaces (see Fig. 7).

The volume of the enlarged gap is preferably a little smaller than the volume of the carbon material at atmospheric pressure. By placing the carbon material in the enlarged gap and connecting the cylindrical members to each other by screws, the carbon material is compressed, and thereby the enlarged gap is filled with the carbon material without any space. As a result, the sealing effect of the carbon material is further increased.

After the carbon material is placed in the enlarged gap and the cylindrical members are connected to each other by screws, the density of the carbon material is preferably not less than 1.0 g/cm³. If the density of the carbon material is less than 1.0 g/cm³, a satisfactory silicon carbide layer cannot be formed when the carbon material comes into contact with a silicon melt, and the carbon is eluted into the silicon melt, resulting in a fear that leakage of the silicon melt cannot be prevented. When the density of the carbon material is not less than 1.0 g/cm³, a strong silicon carbide layer having high ability to prevent penetration of a liquid and capable of inhibiting elution of silicon carbide into the silicon melt can be formed by the contact of the carbon material with the silicon melt. Moreover, it is thought that even if the silicon carbide layer formed is deteriorated or suffers cracks, the residual carbon material reacts with a silicon melt that newly penetrates, whereby a fresh silicon carbide layer can be formed. Consequently, durability of the silicon carbide layer can be much more enhanced.

The upper limit of the density of the carbon material has only to be properly determined according to the compressibility of the carbon material, the surface profile of the connecting butt portion of the carbon molded articles, the amount of the silicon melt to be contacted with the carbon material, the size and shape of the carbon molded article, etc., but in the industrial production of silicon, the density is preferably not more than 2.0 g/cm³ By setting the density of the carbon material to not more than 2.0 g/cm³, the carbon material is imparted with moderate elasticity, and therefore, the carbon material is brought into close contact with the upper and the lower surfaces of the enlarged gap, whereby a space where the silicon melt passes can be effectively filled up.

In order to allow the carbon material having a density of not less then 1.0 g/cm³ to be present in the gap at the butt portion of the carbon molded articles in the invention, a method of spraying a carbon powder having a given particle size to allow the carbon material to be present can be thought, but taking into account the operability in the construction of the carbon columnar container, it is preferable to use a flat plate molded article having a layer structure of graphite that is used as a packing or gasket material or a molded article obtained by compression molding a carbon powder. If a molded article having compressibility is allowed to be present as the molded article of the carbon material, the carbon material is brought into close contact with the upper and the lower surfaces of the enlarged gap, and the gap can be effectively sealed.

The density of the carbon material at the connection portion is calculated from the weight of the carbon material and the volume of the enlarged gap.

The size of the carbon material, namely, the thickness a and the width b of the carbon material, is almost the same as the size of the enlarged gap. That is to say, the thickness a of the carbon material is not specifically restricted and is properly determined according to the material, dimension and strength of the carbon molded article used, the shape of the enlarged gap, the amount of the silicon melt to be contacted with the carbon material, etc. If the thickness is too large, cracks are liable to occur because of a difference in thermal expansion between the carbon material and the resulting silicon carbide layer. Therefore, the thickness is preferably as small as possible. In a reactor for the industrial production of silicon, the thickness a is in the range of preferably 1.0 µm to 1000 µm, more preferably 1.0 µm to 100 µm.

The width b of the carbon material is not specifically restricted either and is properly determined according to the material, dimension and strength of the carbon molded article used, the shape of the butt portion, the amount of the silicon melt to be contacted with the carbon material, etc. In a reactor for the industrial production of silicon, the width b is in the range of preferably about 5.0 to 30.0 mm.

### INDUSTRIAL APPLICABILITY

The carbon columnar container of the invention is constructed by connecting plural carbon cylindrical members, and the gap at the connection portion in the inner peripheral wall is sealed. Therefore, when the carbon columnar container of the invention is used for, for example, manufacturing silicon, there is no fear of breakage of the connection portion attributable to penetration and solidification of a silicon melt in the container wall. Further, because leakage of a raw material gas or a silicon melt due to penetration thereof through the container wall does not occur, the reaction efficiency is excellent, and the circumference of the columnar container is neither contaminated nor damaged. Because the screw portions are surely fixed without any strain and are not loosened, the connection portion has high mechanical strength. By connecting plural members, a large-sized columnar container having sealing property, reliability and strength comparable to those of an integrally molded article can be obtained.

### Examples 1 to 5, Comparative Example 1

A columnar container made of a material of isotropic carbon, having an outer diameter of 75 mm, an inner diameter of 45 mm and a length of 1000 mm and constituted of 5 cylindrical members connected in the lengthwise direction by means of screws provided at the ends of the cylindrical members was prepared. A surface roughness and a width of the ring-shaped plane in the butt area on the inner peripheral wall side in each of the resulting columnar containers are set forth in Table 1.

The columnar container prepared as above was loaded on a polycrystal silicon manufacturing apparatus, and a mixed gas of trichlorosilane (10 kg/h) and hydrogen (40 Nm³/h) was passed through the columnar container. The temperature of the columnar container was raised to not lower than 1450°C by means of high-frequency heating to deposit polycrystal silicon in a molten state for 100 hours, and the polycrystal silicon was continuously dropped from the lower end of the columnar container to obtain silicon. After the reaction, the columnar container was taken out of the manufacturing apparatus, and the condition of the columnar container was examined.

The results are set forth in Table 1.

**Table 1**

| | Sum of surface roughness (Ra) of ring-shaped planes (µm) | Width of ring-shaped plane (mm) | Leakage | Loosening of screw portion |
|---|---|---|---|---|
| Ex. .1 | 1.5 | 5 | none | none |
| Ex. 2 | 50 | 5 | none | none |
| Ex. 3 | 100 | 5 | none | none |
| Ex. 4 | 50 | 1 | none | none |
| Ex. 5 | 50 | 10 | none | none |
| Comp. Ex. 1 | 150 | 5 | observed | none |

## Claims

1. A carbon columnar container constructed so as to form a multistage structure by connecting plural carbon cylindrical members to each other by a screw portion provided along the periphery of an end of each of the cylindrical members, wherein:
each of the cylindrical members connected to each other has such a ring-shaped plane extending from the inner peripheral wall in the diameter direction as to form a ring-shaped butt area on the inner peripheral wall side when the cylindrical members are connected, and
the sum of surface roughness (Ra) of the ring-shaped planes to form the butt area is in the range of 1 to 100 µm.

2. The carbon columnar container as claimed in claim 1, which has a ring-shaped enlarged gap formed at the end, in the outer peripheral direction, of the ring-shaped plane, and wherein a carbon material is placed at the enlarged gap.

3. The carbon columnar container as claimed in claim 1 or 2, wherein the inner peripheral wall surface has been converted into silicon carbide.
